# EUROPEAN PATENT SPECIFICATION

(11) **EP 0 352 769 B1**
(45) Date of publication and mention of the grant of the patent: **13.11.1996**
(21) Application number: 89113789.5
(22) Date of filing: 26.07.1989
(51) Int. Cl.: H03K 17/08

(54) **Input protection circuit for MOS device**
Eingangsschutzschaltung für MOS-Vorrichtung
Circuit de protection d'entrée pour dispositif MOS

(30) Priority: 29.07.1988 JP 190251/88
(43) Date of publication of application: 31.01.1990
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Okada, Yoshio c/o Intellectual Property Division, Minato-ku Tokyo 105 (JP); Imada, Sadao c/o Intellectual Property Division, Minato-ku Tokyo 105 (JP); Shimizu, Mitsuru c/oIntellectual Property Division, Minato-ku Tokyo 105 (JP)
(74) Representative: Lehn, Werner, Dipl.-Ing.

(56) References cited:
- US-A- 4 066 918
- US-A- 4 066 918
- US-A- 4 605 980
- US-A- 4 763 184
- PATENT ABSTRACTS OF JAPAN, vol. 10, no. 125 (E-402)[2182], 10th May 1986; & JP-A-60 257 576 (MITSUBISHI DENKI K.K.) 19-12-1985
- IDEM
- PATENT ABSTRACTS OF JAPAN, vol. 6, no. 251 (E-147)[1129], 10th December 1982; & JP-A-57 152 160 (MITSUBISHI DENKI K.K.) 20-09-1982
- ELECTRONICS, vol. 59, no. 31, September 1986, pages 78-81, New York, US; "TI's blazing-fast CMOS logic takes on schottky bipolar"

## Description

This invention relates to an input protection circuit for MOS devices.

In an ordinary MOS device, the gate thereof is isolated from the remaining portion thereof by a gate oxide film (SiO₂ film) which forms the dielectric layer between the gate and substrate. Since the gate oxide film is very thin, it may be destroyed in the same manner as other dielectric materials if an excessively high voltage is applied to the gate. As a result, the gate and substrate may be short-circuited and the device will be destroyed permanently. Therefore, special care must be taken so as not to accidentally apply excessive charges to the gate.

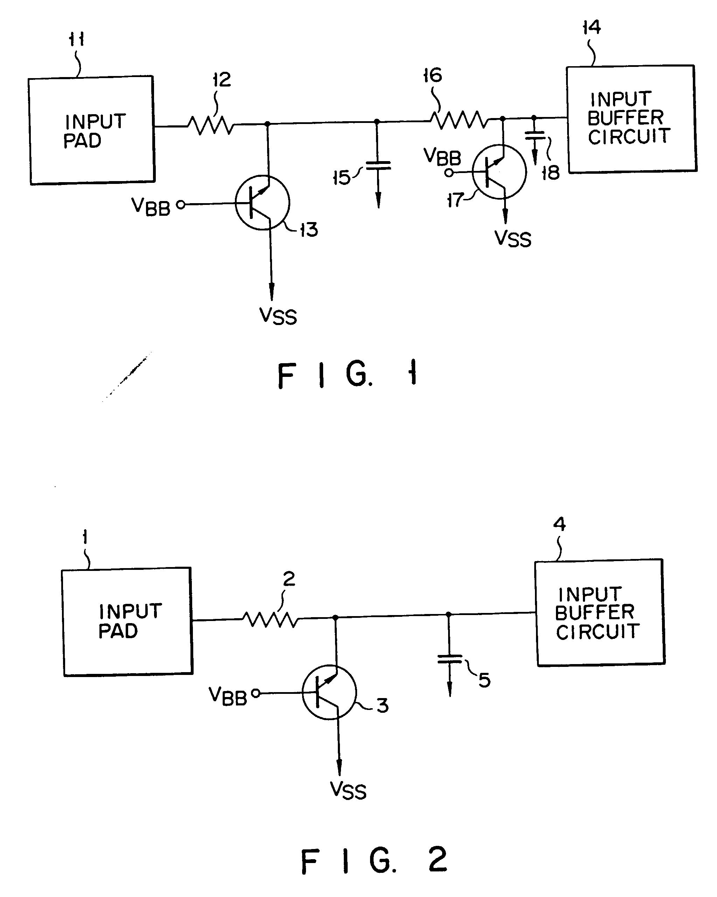

Fig. 2 shows an input protection circuit serving as a protection device for the conventional MOS device. Input pad 1 is connected to one end of resistor (R) 2 formed of a diffusion layer or polysilicon layer and the other end of the resistor is connected to the emitter of parasitic bipolar transistor 3. The collector and base of parasitic bipolar transistor 3 are respectively connected to power source terminal Vss (ground potential) and power source terminal VBB (substrate potential). The other end of resistor 2 is connected to the gate in input buffer circuit 4. In Fig. 2, 5 denotes a parasitic capacitor, (C).

The conventional circuit of the above construction may be insufficient in its ability to protect the gate oxide film of the MOS device from being damaged by static charges or a voltage which is accidentally applied to the gate. For example, in Fig. 2, resistor 2 is formed near input pad 1 and the wiring distance between resistor 2 and input buffer circuit 4 is long. Accordingly, the capacitance of parasitic capacitor (C) 5 is large, therefore the resistance of resistor (R) 2 cannot be large from the viewpoint of wave formation (that is, the waveform will become deformed due to RC). As a result, it is necessary to increase the pattern size of parasitic bipolar transistor 3.

From Electronics, volume 59, No. 31, September 1986, pages 78 to 81, New York, US; "TI's BLAZING-FAST CMOS LOGIC TAKES ON SCHOTTKY BIPOLAR" a circuit for protecting the input of MOS devices is known which includes a diffused transistor connected at its connector and emitter between the input line of the MOS device and a supply voltage terminal. Moreover, a resistor is provided in the input line.

From patent abstract of Japan, volume 10, 125 (E-402) [2182], 10th May, 1986 a protection circuit for MOS devices is known which protects the input of the MOS device against excessive input voltages by means of a network including resistors and diodes. The resistor network serves to divide the input current flowing due to the excessive input voltage such that each diode of the network has to handle a fraction of the flowing current only.

As described above, in order to enhance the ability to protect the gate oxide film of the MOS device from being damaged by static charges or a voltage which is accidentally applied to the gate, it is necessary to increase the pattern size of the parasitic bipolar transistor.

An object of this invention is to provide an input protection circuit for MOS devices in which the gate oxide film can be protected from being damaged by static charges or a voltage which is accidentally applied to the gate, without increasing the pattern size of the clamp element (for example parasitic bipolar transistor) and without causing deformation of an input signal waveform.

The above object can be attained by an input protection circuit for MOS devices, comprising:
An input protection circuit for MOS devices, comprising:
an input pad ; an input buffer circuit of said MOS device; a first resistor connected at its one terminal to said input pad; a first transistor connected at its emitter with the other terminal of said first resistor, its base and collector, respectively, being connected with a substrate terminal and a power source terminal, respectively;
**characteterized by** a second resistor connected between said emitter of said first transistor and said input buffer circuit ; and a second transistor connected at its emitter with said input buffer circuit, its base and collector, respectively, being connected with said substrate terminal and said power source terminal, respectively;
said first transistor being a parasitic transistor formed near said input pad and said second transistor being a parasitic transistor formed near said input buffer circuit; the resistance of said second resistor being higher than that of said first resistor; a capacitance of a parasitic capacitor of a wiring from said second transistor to said input buffer circuit being lower than a capacitance of a parasitic capacitor of a wiring from said first transistor to said second transistor.

With this circuit the gate oxide film of the input buffer circuit can be protected from being damaged by static charges or a voltage which is accidentally applied to the gate, without increasing the pattern size of the first clamp element.
Fig. 1 is a circuit diagram of an input protection circuit for MOS devices according to one embodiment of this invention; and
Fig. 2 is a circuit diagram of the conventional input protection circuit for MOS devices.

This invention can be more fully understood from the following detailed description when taken in conjunction with the accompanying drawings, in which:

Fig. 1 shows an input protection circuit for MOS devices according to one embodiment of this invention. Input pad 11 is connected to one end of first resistor (R1) 12 with a resistance of, for example, 100 Ω, formed of a diffusion layer, polysilicon or wiring material, and the other end of first resistor 12 is connected to a clamp element, such as the emitter of first parasitic bipolar transistor 13 formed of an NPN bipolar transistor. The collector and base of first parasitic bipolar transistor 13 are respectively connected to power source terminal Vss (ground potential) and power source terminal VBB (substrate potential). The other end of first resistor 12 is connected to one end of second resistor (R2) 16 with a resistance of 1 KΩ, for example, formed of a diffusion layer, polysilicon or wiring material, and the other end of second resistor 16 is connected to a second clamp element, such as the emitter second parasitic bipolar transistor 17 formed of an NPN bipolar transistor. The collector and base of second parasitic bipolar transistor 17 are respectively connected to power source terminals Vss and VBB. The other end of second resistor 16 is also connected to the gate of input buffer circuit 14 having at least one MOS device. In Fig. 1, 15 denotes a parasitic capacitor (C1) of the wiring having a capacitance of 2 pF, for example, and 18 denotes a parasitic capacitor (C2) of the wiring having a capacitance of 200 fF, for example.

An object of this invention is to enhance the ability to protect the gate oxide film of the input buffer circuit formed of a MOS device from being damaged by a voltage which is accidentally generated and causes stress, without increasing the pattern size of first parasitic bipolar transistor 13.

To this end, in this embodiment, second resistor (R2) 16 with a resistance of 1 KΩ, for example, formed of a diffusion layer, polysilicon or wiring material, and second parasitic bipolar transistor 17 are connected at a stage immediately before input buffer circuit 14. In order to introduce second parasitic bipolar transistor 17 into the circuit, second resistor 16 is used. The capacitance (C2) of parasitic capacitor 18 of the wiring, which is 200 fF, is less than that (C1) of parasitic capacitor 15 of the wiring, which is 2 pF. Thus, the resistance (R2) of second resistor 16 can be increased to 1 KΩ, without causing the deformation of the waveform. Hence, the current flowing in second parasitic bipolar transistor 17 is small, and transistor 17 requires only a small pattern area.

As described above, according to this invention, the second resistor and the second parasitic bipolar transistor, having a small pattern size, are connected at a stage immediately before the input buffer circuit having a MOS device so that the ability to protect the gate oxide film of the first parasitic bipolar transistor from being damaged can be enhanced without increasing the pattern size of the first parasitic bipolar transistor.

Reference signs in the claims are intended for better understanding and shall not limit the scope.

## Claims

1. An input protection circuit for MOS devices, comprising:
- an input pad (11);
- an input buffer circuit (14) of said MOS device;
- a first resistor (12) connected at its one terminal to said input pad (11);
- a first transistor (13) connected at its emitter with the other terminal of said first resistor (12), its base and collector, respectively, being connected with a substrate terminal (V_{BB}) and a power source terminal (V_{SS}), respectively;
**characterized by**
- a second resistor (16) connected between said emitter of said first transistor (13) and said input buffer circuit (14); and
- a second transistor connected at its emitter with said input buffer circuit (14), its base and collector, respectively, being connected with said substrate terminal (V_{BB}) and said power source terminal (V_{SS}), respectively;
- said first transistor (3) being a parasitic transistor formed near said input pad (11) and said second transistor (17) being a parasitic transistor formed near said input buffer circuit;
- the resistance of said second resistor (16) being higher than that of said first resistor (12);
- a capacitance (C2) of a parasitic capacitor (18) of a wiring from said second transistor (17) to said input buffer circuit (14) being lower than a capacitance (C1) of a parasitic capacitor (15) of a wiring from said first transistor (13) to said second transistor (17).

## Patentansprüche

1. Eingangsschutzschaltkreis für MOS-Vorrichtungen, mit:
- einer Eingangsanschlußfläche (11);
- einem Eingangspuffer-Schaltkreis (14) der MOS-Vorrichtung;
- einem ersten Widerstand (12), der mit seinem einen Anschluß mit der Eingangsanschlußfläche (11) verbunden ist;
- einem ersten Transistor (13), der mit seinem Emitter mit dem anderen Anschluß des ersten Widerstandes (12) verbunden ist, wobei seine Basis bzw. sein Kollektor mit einem Substratanschluß (V_{BB}) bzw. einem Stromversorgungsanschluß (V_{SS}) verbunden sind;
**gekennzeichnet durch**
- einen zweiten Widerstand (16), der zwischen den Emitter des ersten Transistors (13) und den Eingangspuffer-Schaltkreis (14) geschaltet ist; und einen zweiten Transistor, der mit seinem Emitter mit dem Eingangspuffer-Schaltkreis (14) verbunden ist, wobei seine Basis bzw. sein Kollektor mit dem Substratanschluß (V_{BB}) bzw. dem Stromversorgungsanschluß (V_{SS}) verbunden sind;
- wobei der erste Transistor (3) ein parasitärer Transistor ist, der nahe der Eingangsanschlußfläche (11) gebildet ist, und der zweite Transistor (17) ein parasitärer Transistor ist, der nahe dem Eingangspuffer-Schaltkreis gebildet ist;
- wobei der Widerstandswert des zweiten Widerstandes (16) höher ist als der des ersten Widerstandes (12);
- und eine Kapazität (C2) eines parasitären Kondensators (18) einer Verdrahtung von dem zweiten Transistor (17) zu dem Eingangspuffer-Schaltkreis (14) kleiner ist als eine Kapazität (C1) eines parasitären Kondensators (15) einer Verdrahtung von dem ersten Transistor (13) zu dem zweiten Transistor (17).

## Revendications

1. Circuit de protection d'entrée pour dispositifs MOS, comportant :
- un plot d'entrée (11);
- un circuit-tampon d'entrée (14) dudit dispositif MOS;
- une première résistance (12) reliée à sa première extrémité audit plot d'entrée (11);
- un premier transistor (13) avec son émetteur relié à l'autre borne de ladite première résistance (12), sa base et son collecteur, respectivement, étant reliés à une borne de substrat (VBB) et à une borne de source d'alimentation (V_{SS}), respectivement;
caractérisé par
- une seconde résistance (16) montée entre ledit émetteur dudit premier transistor (13) et ledit circuit-tampon d'entrée (14); et
- un second transistor relié par son émetteur audit circuit-tampon d'entrée (14), sa base et son collecteur, respectivement, étant reliés à ladite borne de substrat (V_{BB}) et ladite borne de source d'alimentation (V_{SS}), respectivement;
- ledit premier transistor (3) étant un transistor parallèle formé près dudit plot d'entrée (11) et ledit second transistor (17) étant un transistor parasite formé près dudit circuit-tampon d'entrée;
- la valeur ohmique de ladite seconde résistance (16) étant plus élevée que celle de ladite première résistance (12);
- une capacité (C2) d'un condensateur parasite (18) d'un câblage depuis ledit second transistor (17) audit circuit-tampon d'entrée (14) étant inférieure à une capacité (C1) d'un condensateur parasite (15) d'un câblage allant dudit premier transistor (13) audit second transistor (17).
